# EUROPEAN PATENT APPLICATION

(11) **EP 4 803 955 A1**
(43) Date of publication of application: **09.09.2026**
(21) Application number: 25207083.4
(22) Date of filing: 07.10.2025
(51) Int. Cl.: G02F 1/1333, G09F 9/30, H10K 77/10

(54) **DISPLAY MODULE AND DISPLAY DEVICE**

(30) Priority: 07.03.2025 CN 202510273081
(71) Applicant: Wuhan China Star Optoelectronics Semiconductor Display Technology Co., Ltd., Wuhan, Hubei 430079 (CN)
(72) Inventor: ZHANG, Yang, Wuhan, 430079 (CN); LIAO, Zuomin, Wuhan, 430079 (CN)
(74) Representative: Nederlandsch Octrooibureau

(57) **Abstract**

A display module and a display device are provided. The display module includes a display panel, a protective adhesive layer, and a buffer member. The display panel includes a first body, a second body, and a bending portion connecting the first body and the second body. The first body and the second body are disposed opposite to each other, and the first body is disposed close to a light-emitting surface of the display module. The protective adhesive layer covers the bending portion, a part of the first body, and a part of the second body. The buffer member partially overlaps the protective adhesive layer covering the second body. The present application improves the stability of the display device.

## Description

### TECHNICAL FIELD

The present application relates to the field of display, and in particular, to a display module and a display device.

### BACKGROUND

With the development trend of electronic devices pursuing extremely full-screen displays, display devices (such as mobile phones) on the market are emerging in an endless stream. In order to pursue diversification in the appearance of the display devices, the narrow-bezel design of the display devices is particularly important.

In a current narrow-bezel display device, during a drop test on the lower bezel of the display device, since no module structure is provided between a bending portion and a cover plate layer of a display panel, when the cover plate layer is subjected to force, the rebound displacement of a planar portion of the display panel is smaller than the rebound displacement of the bending portion. This causes the bending portion to deform due to contact with the cover plate layer, leading to technical problems such as bright lines in the display device.

### SUMMARY

The present application provides a display module and a display device to improve the problem of poor stability of existing display devices.

The present application is set out in the appended set of claims.

Some embodiments of the present application provide a display module, including:
a display panel including a first body, a second body, and a bending portion connecting the first body and the second body, where the first body and the second body are disposed opposite to each other, and the first body is disposed close to a light-emitting surface of the display module;
a protective adhesive layer covering the bending portion, a part of the first body, and a part of the second body; and
a buffer member disposed on a side of the second body away from the first body, where the buffer member partially overlaps the protective adhesive layer covering the second body.

Some embodiments of the present application further provide a display device. The display device includes a middle frame and the aforementioned display module disposed in the middle frame, and a surface of the buffer member away from the second body is connected to the middle frame.

### BRIEF DESCRIPTION OF THE DRAWINGS

In order to explain technical solutions in embodiments of the present application more clearly, the following will briefly introduce the drawings needed to be used in description of the embodiments. Apparently, the drawings in the following description are only some embodiments of the present application. For ordinary skilled in the art, other drawings can be obtained from these drawings without paying creative effort.
FIG. 1 is a schematic diagram of a planar structure of a display device according to some embodiments of the present application.
FIG. 2 is a schematic diagram of a first cross-sectional view along a direction AA in FIG. 1.
FIG. 3 is a schematic diagram of a second cross-sectional view along the direction AA in FIG. 1.
FIG. 4 is a schematic diagram of a third cross-sectional view along the direction AA in FIG. 1.
FIG. 5 is a schematic diagram of a fourth cross-sectional view along the direction AA in FIG. 1.
FIG. 6 is a schematic diagram of a fifth cross-sectional view along the direction AA in FIG. 1.
FIG. 7 is a schematic diagram of a cross-sectional structure of a display panel in a display module according to some embodiments of the present application.
FIG. 8 is a schematic diagram of a structure of a cover plate layer in FIG. 3.
FIG. 9 is a schematic diagram of a sixth cross-sectional view along the direction AA in FIG. 1.
FIG. 10 is a schematic diagram of a first positional relationship between a polarizer and a buffer member in the display device according to some embodiments of the present application.
FIG. 11 is a schematic diagram of a second positional relationship between the polarizer and the buffer member in the display device according to some embodiments of the present application.
FIG. 12 is a schematic diagram of a third positional relationship between the polarizer and the buffer member in the display device according to some embodiments of the present application.

### DETAILED DESCRIPTION

Technical solutions in the embodiments of the present application will be clearly and completely described with reference to the drawings. Apparently, the described embodiments are only part of the embodiments of the present application, not all of them. According to the embodiments of the present application, all other embodiments obtained by those skilled in the art without making creative efforts shall fall within the scope of protection of the present application.

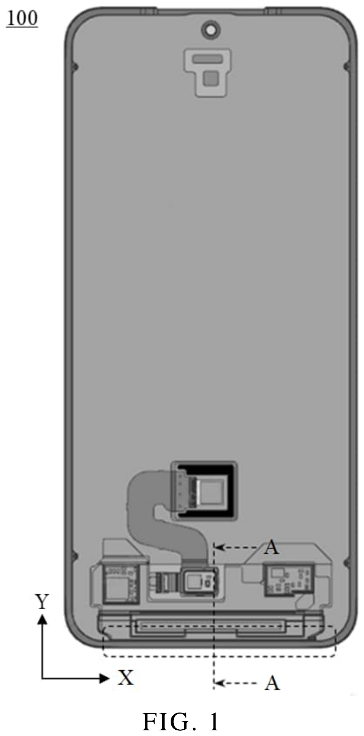

Referring to FIGs. 1 to 12, some embodiments of the present application provide a display device 100, which includes a middle frame 300 and a display module 200 disposed in the middle frame 300. The display module 200 may include a display panel 10, a protective adhesive layer 80, and a buffer member 30.

In the above embodiments, the display panel 10 includes a first body 110, a second body 120, and a bending portion 130 connecting the first body 110 and the second body 120. The first body 110 and the second body 120 are disposed opposite to each other. The first body 110 is disposed close to a light-emitting surface 10a of the display module 200, that is, the first body 110 is disposed facing a light-emitting side of the display module 200.

In some embodiments, the protective adhesive layer 80 may cover the bending portion 130, a part of the first body 110, and a part of the second body 120.

In some embodiments, the buffer member 30 may be disposed on a side of the second body 120 away from the first body 110. The buffer member 30 partially overlaps the protective adhesive layer 80 covering the second body 120.

It should be noted that the first body 110 and the second body 120 of the present application may constitute a planar portion of the display panel 10.

It should be noted that the display module 200 further includes a polarizer PL disposed on a side of the first body 110 away from the second body 120, a cover plate layer 50, and an optical adhesive layer 60 disposed between the polarizer PL and the cover plate layer 50, and the protective adhesive layer 80 covers a part of the first body 110.

It should be noted that in the coating process of the protective adhesive layer 80, the protective adhesive layer 80 is generally brought into contact with a side surface of the polarizer PL. However, air bubbles usually exist between the protective adhesive layer 80 and the polarizer PL, resulting in weak adhesion between them. This may cause separation at the interface between the protective adhesive layer 80 and the polarizer PL during subsequent processing steps.

In addition, when a drop test is performed on the lower bezel of the display device, i.e., in the region where the bending portion 130 is located, due to the gap between a side of the display module 200 away from the light-emitting surface 10a and the middle frame 300, when the cover plate layer 50 is subjected to force, the cover plate layer 50 may transmit the force to the planar portion of the display panel 10 through the polarizer PL and the optical adhesive layer 60. This causes the cover plate layer 50 and the planar portion of the display panel 10 to displace toward the middle frame 300, while the planar portion drives the bending portion 130 to displace toward the middle frame 300. During the rebound process of the planar portion of the display panel 10, the polarizer PL and the optical adhesive layer 60 between the planar portion and the cover plate layer 50 can maintain the stability of the planar portion. However, since no module structure is provided between the bending portion 130 of the display panel 10 and the cover plate layer 50, the displacement generated by the bending portion 130 is greater than the displacement generated by the planar portion. This causes deformation of the bending portion 130 due to contact with the cover plate layer 50, and the interface between the protective adhesive layer 80 and the polarizer PL is affected by the displacement of the bending portion 130, leading to further aggravation of the separation between the protective adhesive layer 80 and the polarizer PL at their interface.

Furthermore, during the drop test, the bending portion 130 will be in an outward bending state. The outermost layer of the display panel 10 is provided with an inorganic layer, such as the inorganic layer of a touch layer, which is the farthest from the neutral layer of the display panel 10. When the deformation generated by the inorganic layer exceeds its own elongation at break, the technical problem of fracture may occur in the inorganic layer. In addition, the aggravation of cracks may penetrate internal film layers, leading to problems such as bright lines in the display device.

It should be noted that, in some embodiments, a surface of the buffer member 30 away from the second body 120 may be connected to the middle frame 300.

Therefore, in the present application, by providing the buffer member 30 on a side of the second body 120 away from the first body 110, when a drop test is performed on the lower bezel of the display device and the cover plate layer 50 is subjected to force, the cover plate layer 50 transmits the force to the planar portion of the display panel 10 through the polarizer PL and the optical adhesive layer 60 located between the planar portion of the display panel 10 and the cover plate layer 50. Due to the presence of the buffer member 30, the buffer member 30 applies a supporting force toward the cover plate layer 50 to the planar portion of the display panel 10, so as to reduce the displacement of the structure in the region where the first body 110 and the second body 120 are located. Consequently, this reduces the force applied by the first body 110 and the second body 120 to the bending portion 130, that is, reduces the rebound displacement of the bending portion 130, avoids the deformation of the bending portion 130 caused by the contact with the cover plate layer 50, improves the problems of separation at the interface between the protective adhesive layer 80 and the polarizer PL, and cracks in the lower bezel region of the display panel 10, thus enhancing the stability of the display device.

In some embodiments, the buffer member 30 has a thickness greater than or equal to 0.2 millimeters, so that the buffer member 30 is in contact with the middle frame 300. Meanwhile, after the installation of the display module 200 and the middle frame 300 is completed, the buffer member 30 may be in a compressed state or a non-compressed state.

It should be noted that a material of the buffer member 30 may be foam, silicone, etc.

It should be noted that the display device 100 provided in the present application may include an electronic device with display functions, such as a mobile phone, a television, or a laptop.

The technical solutions of the present application will be described below in conjunction with specific embodiments.

In some embodiments, the first body 110 includes a display region and a non-display region disposed adjacent to the display region. For example, the non-display region surrounds the display region such that the display region is surrounded by the non-display region. The display region is a region within the display panel 10 for performing display functions, and a plurality of display units for realizing the display functions are provided in the display region. The non-display region may refer to a bezel region of the display panel 10, within which functional components that assist the display units in the display region with their display functions may be arranged.

In some embodiments, the second body 120 is provided with a bonding terminal 121 that may be connected to an external circuit. The bonding terminal 121 transmits a signal input from an external circuit to a data trace, thereby driving the display panel 10 to display images. For example, the bonding terminal 121 may be bonded and connected to a driver chip IC or the like, and is used to provide power, driving signals, etc., for the display panel 10.

In some embodiments, the bending portion 130 is provided with a plurality of fan-out traces to achieve data transmission between the second body 120 and the first body 110.

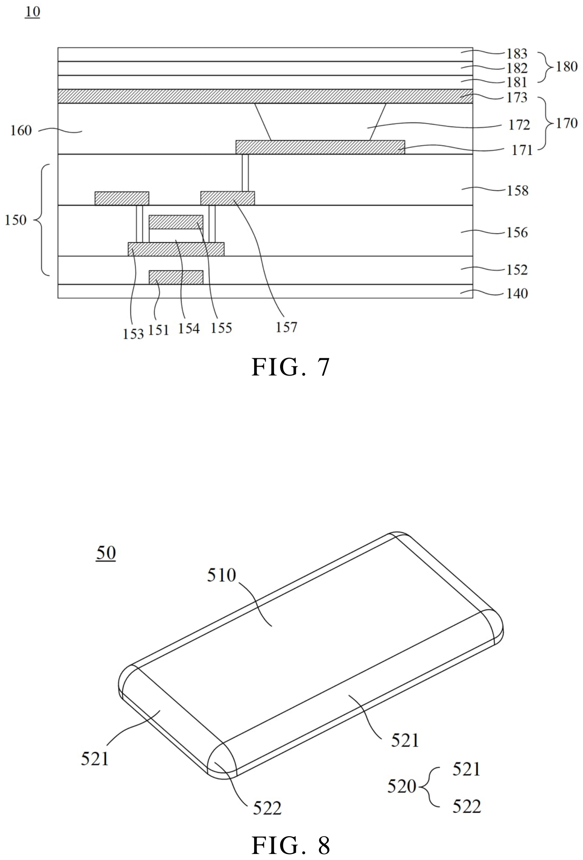

Referring to FIG. 7, the display panel 10 may include a base substrate 140, a driver circuit layer 150 disposed on the base substrate 140, a pixel definition layer 160 and a light-emitting device layer 170 disposed on the driver circuit layer 150, and an encapsulation layer 180 disposed on the pixel definition layer 160.

In the above embodiments, the base substrate 140 is configured to support film layers that are disposed on the base substrate 140. When the display device 100 is a bottom-emission light-emitting display device or a double-sided emission light-emitting display device, the base substrate 140 may adopt a transparent substrate. When the display device 100 is a top-emission light-emitting display device, the base substrate 140 may adopt a translucent substrate, an opaque substrate, or a transparent substrate.

In some embodiments, the base substrate 140 is made of an insulating material such as glass, quartz, or polymer resin. The base substrate 140 may be a rigid substrate or a flexible substrate that can be bent, folded, curled, etc. Examples of flexible materials for the flexible substrate include polyimide (PI), but is not limited thereto.

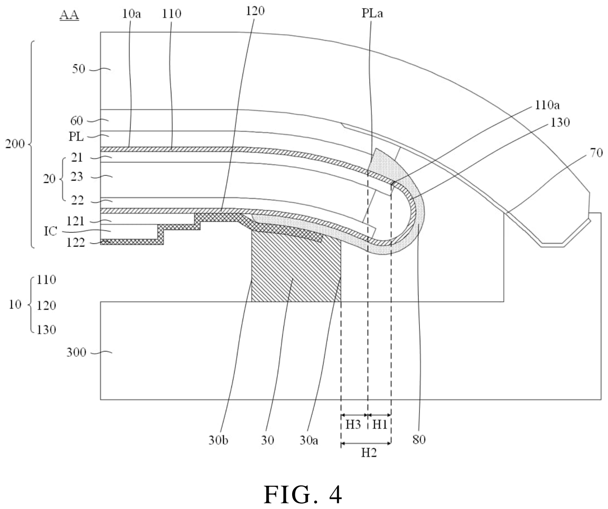

As illustrated in FIG. 7, the driver circuit layer 150 may include a plurality of thin film transistors (TFTs). The TFTs may be of an etch-stop type or a back-channel etch type, or may be classified into bottom-gate TFTs or top-gate TFTs according to the positional relationship between the gate and the active layer. The present application does not limit on this. For example, the thin film transistor illustrated in FIG. 4 is a top-gate thin film transistor, which may include a light-shielding unit 151 disposed on the base substrate 140, a buffer layer 152 disposed on the light-shielding unit 151, an active layer 153 disposed on the buffer layer 152, a gate insulating layer 154 disposed on the active layer 153, a gate layer 155 disposed on the gate insulating layer 154, an interlayer insulating layer 156 disposed on the gate layer 155, a source/drain layer 157 disposed on the interlayer insulating layer 156, and a planarization layer 158 disposed on the source/drain layer 157. The structure of the thin film transistor shown in FIG. 7 is merely an example of the present application, and other types of thin film transistors are also applicable to the present application.

As illustrated in FIG. 7, the light-emitting device layer 170 may include an anode layer 171 disposed on the planarization layer 158, a light-emitting layer 172 disposed on the anode layer 171, and a cathode layer 173 disposed on the light-emitting layer 172. The anode layer 171 includes a plurality of anodes. The pixel definition layer 160 includes a plurality of pixel openings corresponding one-to-one to the plurality of anodes, and each pixel opening exposes an upper surface of one anode. The light-emitting layer 172 may include a plurality of light-emitting pixels corresponding one-to-one to the plurality of anodes.

As illustrated in FIG. 7, the encapsulation layer 180 covers the pixel definition layer 160 and continuously covers the plurality of pixel openings and the plurality of light-emitting pixels. The encapsulation layer 180 may include a first inorganic encapsulation layer, a first organic encapsulation layer, and a second inorganic encapsulation layer that are stacked on the pixel definition layer 160.

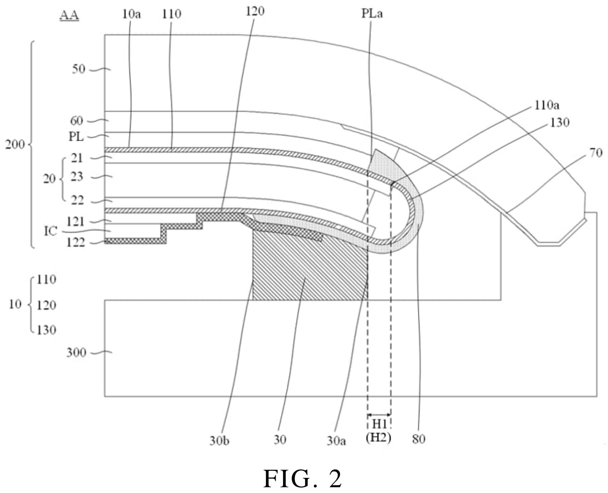

Referring to FIGs. 2 to 6, the display module 200 further includes the polarizer PL, the cover plate layer 50, and the optical adhesive layer 60 disposed between the polarizer PL and the cover plate layer 50. The cover plate layer 50 is bonded and connected to the polarizer PL through the optical adhesive layer 60.

In some embodiments, a ring-shaped ink layer 70 may be disposed on a side of the cover plate layer 50 close to the optical adhesive layer 60. The ink layer 70 is used to shield the peripheral region of the display module 200, thus defining the edge region of the display module 200.

Referring to FIGs. 2 to 6, the display module 200 further includes a composite support layer 20 disposed between the first body 110 and the second body 120. The composite support layer 20 includes a first backplane 21, a second backplane 22, and a functional support layer 23 provided between the first backplane 21 and the second backplane 22. The first backplane 21 is in contact with the first body 110. The second backplane 22 is in contact with the second body 120.

In some embodiments, both a material of the first backplane 21 and a material of the second backplane 22 may include polyethylene terephthalate or the like.

In some embodiments, the functional support layer 23 may include a heat dissipation buffer layer (Super Clean Foam, SCF) and a filling adhesive layer (Stiffener, STF). The filling adhesive layer is disposed between the second backplane 22 and the heat dissipation buffer layer. The heat dissipation buffer layer may include a grid adhesive layer, a foam layer, and a metal layer that are stacked in sequence. Alternatively, the heat dissipation buffer layer may include a grid adhesive layer, a foam layer, a polyimide layer, and a metal layer that are stacked in sequence.

It should be noted that for a foldable display device, the functional support layer 23 may include a stacked structure of a buffer layer, a rigid layer, and a heat dissipation layer. A material of the buffer layer may be foam or polyimide, a material of the rigid layer may be stainless steel, titanium, or carbon fiber, and a material of the heat dissipation layer may be graphite or copper.

In some embodiments, a boundary of the heat dissipation buffer layer close to the bending portion 130 is retracted relative to a boundary of the first backplane 21 close to the bending portion 130, and a boundary of the filling adhesive layer close to the bending portion 130 is retracted relative to a boundary of the second backplane 22 close to the bending portion 130.

In some embodiments, the display module 200 further includes the protective adhesive layer 80 disposed on the display panel 10. The protective adhesive layer 80 covers the bending portion 130, a part of the first body 110, and a part of the second body 120.

In some embodiments, a material of the protective adhesive layer 80 may be an ultraviolet curable adhesive.

It should be noted that the technical solutions of the present application are applicable to both non-foldable display devices and foldable display devices. For a non-foldable display device, the cover plate layer 50 may be a hard cover plate layer. For a foldable display device, the cover plate layer 50 may include an ultra-thin glass and a protective layer with a built-in optical adhesive.

It should be noted that the technical solutions of the present application are applicable to both four-sided curved display devices and non-four-sided curved display devices. For example, for a four-sided curved display device, since the cover plate layer 50 is bent at the edge region, a distance between the bending portion 130 and the cover plate layer 50 is less than that of a non-four-sided curved display device. During a drop test, the bending portion 130 of the four-sided curved display device is more likely to come into contact with the cover plate layer 50.

Referring to FIG. 8, the cover plate layer 50 includes a planar portion 510 and a curved portion 520 located at a periphery of the planar portion 510. The curved portion 520 includes a plurality of side sub-portions 521 located at a peripheral side of the planar portion 510 and a corner sub-portion 522 located between two adjacent side sub-portions 521.

In some embodiments, the buffer member 30 partially overlaps the side sub-portion 521 corresponding to the bending portion 130 and partially overlaps the corner sub-portions 522 corresponding to the bending portion 130. In the present application, the buffer member 30 is provided in the region where the lower bezel of the display module 200 is located, and the buffer member 30 partially overlaps the side sub-portion 521 corresponding to the bending portion 130 and partially overlaps the corner sub-portions 522 located at both sides of the side sub-portion 521. This configuration reduces the rebound displacement of the planar portion of the display panel 10 in the region where the lower bezel is located, thus decreasing the force applied by the planar portion of the display panel 10 to the bending portion 130. As a result, the rebound displacement of the bending portion 130 is decreased, avoiding deformation of the bending portion 130 caused by the contact with the cover plate layer 50, thus improving the stability of the display device.

It should be noted that since the protective adhesive layer 80 and the polarizer PL are prone to separation at their interface, and the fracture of the outermost inorganic layer of the display panel 10 also occurs at this interface, the buffer member 30 can be designed specifically for this region.

Referring to FIG. 2, the polarizer PL includes a first side surface PLa close to the bending portion 130, the buffer member 30 includes a second side surface 30a close to the bending portion 130, and the first body 110 includes a fourth side surface 110a close to the bending portion 130. A distance H1 between the first side surface PLa and the fourth side surface 110a is equal to a distance H2 between the second side surface 30a and the fourth side surface 110a.

Since the protective adhesive layer 80 and the polarizer PL are prone to separation at their interface, a boundary of the buffer member 30 can be defined with reference to a boundary corresponding to the first side surface PLa of the polarizer PL. The buffer member 30 can apply a supporting force toward the cover layer 50 to the structures in the display module 200 that overlaps the buffer member 30, thus reducing the displacement of the structures overlapping the buffer member 30 toward the middle frame 300. This reduction in displacement further decreases the force applied to the bending portion 130 in this region, minimizing the rebound displacement of the bending portion 130. As a result, deformation of the bending portion 130 caused by the contact with the cover plate layer 50 is avoided, and the stability of the display device is improved.

It should be noted that the boundary of the buffer member 30 shall not exceed the boundary corresponding to the first side surface PLa (the boundary of the polarizer PL). During a drop test, the buffer member 30 may apply a supporting force toward the cover plate layer 50 to the region where the structures overlapping the buffer member 30 are located. However, since no module structure is provided in the region between the first side surface PLa and the bending portion 130 in the display module 200, the bending portion 130 may shift toward the cover plate layer 50 due to the force applied by the buffer member 30, which may cause deformation problems due to the contact between the bending portion 130 and the cover plate layer 50.

In the structure illustrated in FIG. 2, the first side surface PLa is an inclined surface, and the plane where the position of the first side surface PLa in contact with the display panel 10 is located (perpendicular to the display panel 10) is defined as the plane where the first side surface PLa is located.

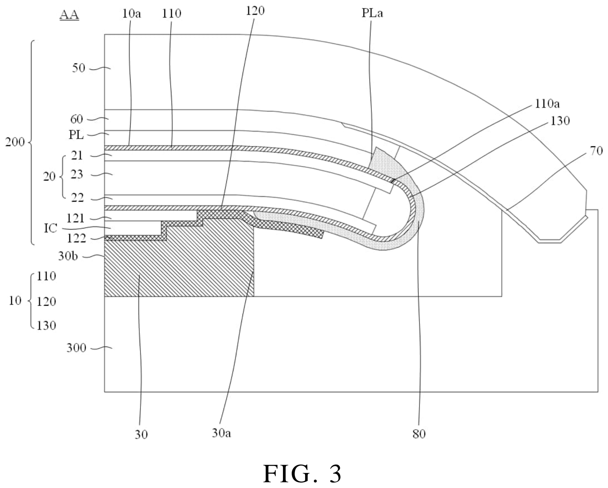

Referring to FIG. 3, the structure illustrated in FIG. 3 is different from the structure illustrated in FIG. 2 in that the distance H1 between the first side surface PLa and the fourth side surface 110a is less than the distance H2 between the second side surface 30a and the fourth side surface 110a, that is, the buffer member 30 may be retracted toward the display region relative to the first side surface PLa. Furthermore, the second side surface 30a may be coplanar with a plane where a boundary of the protective adhesive layer 80 away from the bending portion 130 is located. In the present application, it is assumed that a side surface of the protective adhesive layer 80 away from the bending portion 130 is perpendicular to the plane where the display panel 100 is located, the plane where the boundary of the protective adhesive layer 80 away from the bending portion 130 is located refers to the side surface of the protective adhesive layer 80 away from the bending portion 130.

It can be understood that when the second side surface 30a of the buffer member 30 does not overlap the protective adhesive layer 80, during a drop test, the buffer member 30 will not apply a supporting force toward the cover plate layer 50 to the module structure that is not in contact with the buffer member 30. This causes the module structure not in contact with the buffer member 30 to displace toward the middle frame 300. Consequently, during the rebound process, the displacement generated by the bending portion 130 will be greater than the displacement generated by the planar portion of the display panel 10, leading to deformation of the bending portion 130 due to the contact with the cover plate layer 50. Therefore, in some embodiments, the buffer member 30 partially overlaps the protective adhesive layer 80, so as to address the deformation issue caused by the contact between the bending portion 130 and the cover plate layer 50.

Different from the structures illustrated in FIG. 2 and FIG. 3, in some embodiments, as illustrated in FIG. 4, the second side surface 30a may be located between the plane where the first side surface PLa is located and the plane where the boundary of the protective adhesive layer 80 away from the bending portion 130 is located.

In some embodiments, a distance H3 between the first side surface PLa and the second side surface 30a may be greater than or equal to 100 micrometers and less than or equal to 300 micrometers. For example, the distance H3 between the first side surface PLa and the second side surface 30a may be 200 micrometers.

In some embodiments, as illustrated in FIG. 2 and FIG. 4, the buffer member 30 includes a third side surface 30b away from the bending portion 130. The third side surface 30b may be coplanar with the plane where the boundary of the protective adhesive layer 80 away from the bending portion 130 is located.

It can be understood that a contact area between the buffer member 30 and the display module 200 shall not be too small. If the contact area is too small, the supporting force applied by the buffer member 30 to the display module 200 will be relatively weak, causing the planar portion of the display panel 10 to still generate displacement toward the middle frame 300. Consequently, during the rebound process of the planar portion, the displacement generated by the bending portion 130 will be greater than the displacement generated by the planar portion, leading to deformation of the bending portion 130 due to the contact with the cover plate layer 50.

As illustrated in FIG. 2 and FIG. 4, in order to address the above problem, an orthographic projection of the buffer member 30 on the protective adhesive layer 80 may be made to completely fall within the protective adhesive layer 80. That is, the third side surface 30b may be coplanar with the plane where the boundary of the protective adhesive layer 80 away from the bending portion 130 is located.

In some embodiments, the display module 200 further includes a driver chip IC disposed on a side of the second body 120 away from the first body 110, and a shielding layer 122 covering the driver chip IC. The driver chip IC is bonded and connected to the bonding terminal 121 provided on the second body 120. The shielding layer 122 may cover a part of the protective adhesive layer 80.

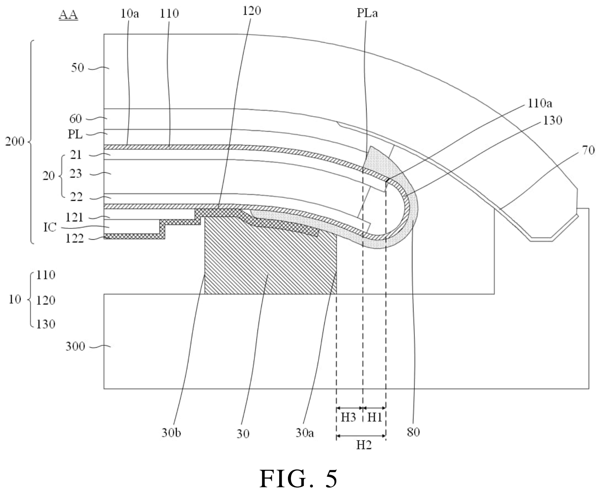

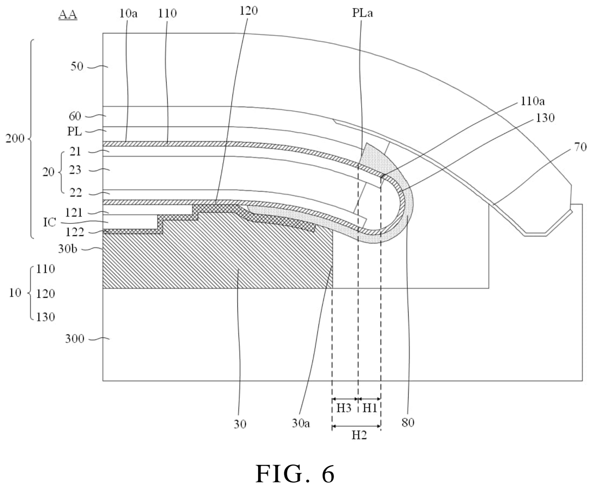

In order to enhance the supporting force applied by the buffer member 30 to the module structure, the contact area between the buffer member 30 and the module structure can be increased. For example, as illustrated in FIG. 5 and FIG. 6, in some embodiments, the third side surface 30b of the buffer member 30 may extend toward the region where the driver chip IC is located.

Referring to FIG. 5, in some embodiments, the third side surface 30b is located between the driver chip IC and the protective adhesive layer 80. Furthermore, in some embodiments, an orthographic projection of the third side surface 30b on the second body 120 is located within an orthographic projection of the driver chip IC on the second body 120, and the buffer member 30 may partially overlap the driver chip IC. That is, the third side surface 30b of the buffer member 30 may extend into the region where the driver chip IC is located. Referring to FIG. 6, in some embodiments, the third side surface 30b is coplanar with a side surface of the driver chip IC away from the protective adhesive layer 80. The buffer member 30 may completely cover the driver chip IC, that is, the boundary of the buffer member 30 away from the protective adhesive layer 80 is flush with the boundary of the driver chip IC away from the protective adhesive layer 80.

It can be understood that since the functional support layer 23 of the present application is not laid as a full layer but is only disposed between the second backplane 22 and the first backplane 21, if the buffer member 30 continues to extend toward a side of the driver chip IC away from the protective adhesive layer 80, the supporting force applied by the buffer member 30 will directly act on the second body 120 without being transmitted to the first body 110. This may increase the risk of fracture of film layers disposed on the second body 120. Therefore, in some embodiments, the third side surface 30b may not be coplanar with the side surface of the driver chip IC away from the protective adhesive layer 80.

In some embodiments, when the buffer member 30 is in direct contact with the display module 200, an elastic modulus of the buffer member 30 shall not be too small. For example, the elastic modulus of the buffer member 30 may be less than the elastic modulus of the protective adhesive layer 80.

In some embodiments, the elastic modulus of the buffer member 30 may range from 500 Kpa to 4 Gpa.

In some embodiments, the buffer member 30 may include a plurality of buffer portions that are disposed in a stacked configuration, and an elastic modulus of one of the buffer portions close to the second body 120 is less than an elastic modulus of one of the buffer portions away from the second body 120.

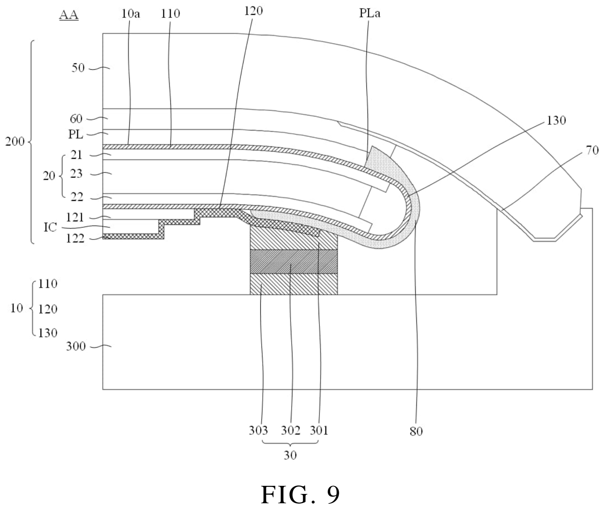

Referring to FIG. 9, in some embodiments, the buffer member 30 may include a first buffer portion 301, a second buffer portion 302, and a third buffer portion 303 that are disposed in a stacked configuration. The first buffer portion 301 is connected to the module structure, the third buffer portion 303 is connected to the middle frame 300, and the second buffer portion 302 is disposed between the first buffer portion 301 and the third buffer portion 303. Since the first buffer portion 301 is directly connected to the module structure, if the elastic modulus of the first buffer portion 301 is relatively high, it may cause certain damage to the module structure. Therefore, by reducing the elastic modulus of the first buffer portion 301, i.e., setting the elastic modulus of the first buffer portion 301 to be less than the elastic modulus of the third buffer portion 303, the damage caused by the first buffer portion 301 to the display module 200 can be improved. Meanwhile, the elastic modulus of the second buffer portion 302 may be greater than or equal to the elastic modulus of the first buffer portion 301 and less than or equal to the elastic modulus of the third buffer portion 303.

In some embodiments, the thicknesses of the first buffer portion 301, the second buffer portion 302, and the third buffer portion 303 can be designed differently. For example, since the first buffer portion 301 has the smallest elastic modulus, its thickness can be set to be the smallest, while the third buffer portion 303, which has the largest elastic modulus, can be set to be the thickest. This configuration increases the support provided by the buffer member 30 to the module structure.

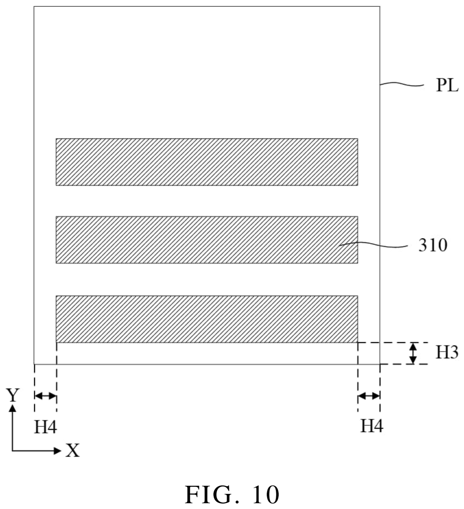

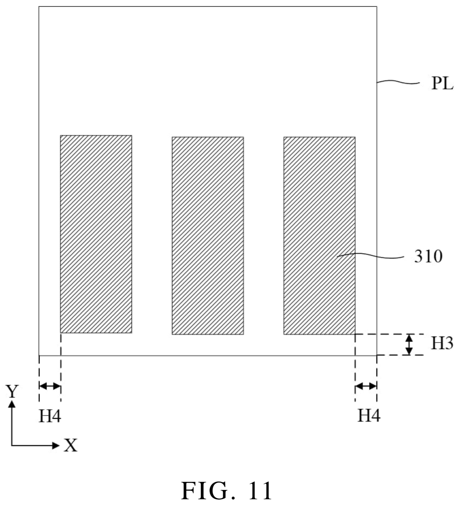

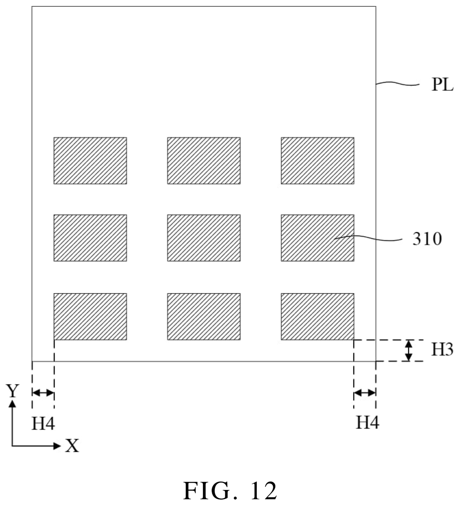

In some embodiments, the buffer member 30 includes a plurality of buffer units 310 arranged at intervals in a width direction X or/and a length direction Y of the display module 200. For example, as illustrated in FIG. 10, in some embodiments, a plurality of buffer units 310 may be arranged at intervals in the length direction Y of the display module 200. As illustrated in FIG. 11, in some embodiments, a plurality of buffer units 310 may be arranged at intervals in the width direction X of the display module 200. As illustrated in FIG. 12, in some embodiments, a plurality of buffer units 310 may be arranged at intervals in both the width direction X and the length direction Y of the display module 200.

It should be noted that, for the convenience of describing the positional relationship between the buffer member 30 and the polarizer PL, FIGs. 10 to 12 only illustrate the positional relationship between the polarizer PL and the buffer member 30.

In some embodiments, among the plurality of buffer units 310 arranged in the width direction X of the display module 200, a distance H4 between a boundary of the outermost buffer unit 310 and a boundary of the polarizer PL is greater than or equal to 100 micrometers and less than or equal to 300 micrometers.

It should be noted that the boundary of the outermost buffer unit 310 in the width direction X may coincide with the boundary of the polarizer PL.

As illustrated in FIGs. 10 to 12, in the width direction X of the display module 200, the distance H4 between the boundary of the outermost buffer unit 310 and the boundary of the polarizer PL is greater than or equal to 100 micrometers and less than or equal to 300 micrometers. That is, a distance between an outer contour of the buffer member 30 and an outer contour of the polarizer PL is greater than or equal to 100 micrometers and less than or equal to 300 micrometers.

In some embodiments, in a region where the bending portion 130 of the display module 200 is located, the outer contour of the buffer member 30 may be disposed parallel to the outer contour of the polarizer PL or/and an outer contour of the display panel 10.

In some embodiments, an upper surface of the corner sub-portion 522 of the cover plate layer 50 is a Gaussian curved surface, and a flexible material of the corner portion 522 may be subjected to forces in various directions, causing a region where the corner sub-portion 522 is located to be prone to wrinkles. Therefore, the material of the buffer member 30 corresponding to the corner sub-portion 522 can be increased. For example, the elastic modulus of the buffer member 30 corresponding to the corner sub-portion 522 can be made larger than the elastic modulus of the buffer member 30 in other regions, so as to improve the supporting force applied by the buffer member 30 to the module structure in the region where the Gaussian curved surface is located, thus preventing the bending portion 130 from contacting the corner sub-portion 522 in this region.

In some embodiments, since a surface of the buffer member 30 away from the second body 120 is in contact with the middle frame 300, in order to ensure the flatness of the contact between the buffer member 30 and the middle frame 300, the surface of the buffer member 30 away from the second body 120 may be configured as a flat surface. That is, the buffer member 30 may be designed with a non-uniform thickness.

In some embodiments, the buffer member 30 may be formed by a dispensing process. For example, during the assembly with the middle frame 300, the dispensing process for the buffer member 30 may be performed first, and after curing, the display module 200 with the buffer member 30 may be assembled with the middle frame 300.

It should be noted that, in some embodiments, the dispensing process may be performed on the middle frame 300 in advance, and then the display module 200 may be assembled with the middle frame 300. In the present application, it is preferable to perform the bonding process between the buffer member 30 and the display module 200 in advance, so as to improve the bonding accuracy between the buffer member 30 and the display module 200 and avoid the risk of misalignment between the buffer member 30 and the bending portion 130.

In some embodiments, since the buffer member 30 partially overlaps the protective adhesive layer 80, and the protective adhesive layer 80 and the buffer member 30 are formed in two processes, a gelation rate of the buffer member 30 and a gelation rate of the protective adhesive layer 80 may be different.

It should be noted that the gelation rate in the present application refers to a mass fraction of the gel formed during the crosslinking process of a polymer, which characterizes the degree of crosslinking of the polymer. The gelation rate is related to the type and content of the crosslinking agent, as well as reaction conditions such as temperature, time, and pressure. Therefore, the different gelation rates of the buffer member 30 and the protective adhesive layer 80 in the present application indicate that they are formed in different process steps.

In some embodiments, the buffer member 30 may be integrated with the shielding layer 122. For example, the buffer member 30 may be directly formed on the shielding layer 122, such that the process of forming the buffer member 30 is completed simultaneously when the shielding layer 122 is bonded.

In some embodiments, an adhesive force between the buffer member 30 and the module structure may be greater than an adhesive force between the buffer member 30 and the middle frame 300. The adhesive force between the buffer member 30 and the module structure is relatively large, which prevents displacement between the buffer member 30 and the module structure from causing damage to the module structure.

The present application provides the display panel and the display device as described above. The display module includes the display panel, the protective adhesive layer, and the buffer member. The display panel includes the first body, the second body, and the bending portion connecting the first body and the second body. The first body and the second body are disposed opposite to each other, and the first body is disposed close to the light-emitting surface of the display module. In the present application, the buffer member is provided on a side of the second body away from the first body to reduce the displacement of the structures in the region where the first body and the second body of the display panel are located in the case where the cover plate layer is subjected to force. This reduces the force applied by the first body and the second body to the bending portion, i.e., decreases the rebound displacement of the bending portion, and avoids the contact between the bending portion and the cover plate layer, thus improving the stability of the display device.

In the above embodiments, the description of each embodiment has its own emphasis, and for parts not described in detail in a certain embodiment, please refer to the relevant description of other embodiments.

The display panel and the display device provided by the embodiments of the present application are described in detail above, and specific embodiments are applied in the present application to explain the principles and implementations of the present application, and the description of the above embodiments is only used to help understand the technical solutions and core ideas of the present application. Those skilled in the art should understand that the technical solutions described in the above embodiments can still be modified, or some technical features can be equivalently replaced. However, these modifications or substitutions do not cause the essence of the corresponding technical solutions to deviate from the scope of the technical solutions of each embodiment of the present application.

## Claims

1. A display module (200), **characterized in that** the display module (200) comprises:
a display panel (10) comprising a first body (110), a second body (120), and a bending portion (130) connecting the first body (110) and the second body (120), wherein the first body (110) and the second body (120) are disposed opposite to each other, and the first body (110) is disposed close to a light-emitting surface (10a) of the display module (200);
a protective adhesive layer (80) covering the bending portion (130), a part of the first body (110), and a part of the second body (120); and
a buffer member (30) disposed on a side of the second body (120) away from the first body (110), wherein the buffer member (30) partially overlaps the protective adhesive layer (80) covering the second body (120).

2. The display module (200) according to claim 1, further comprising a polarizer (PL) disposed on a side of the first body (110) away from the second body (120), wherein the polarizer (PL) comprises a first side surface (PLa) close to the bending portion (130); and
wherein the buffer member (30) comprises a second side surface (30a) close to the bending portion (130), and the second side surface (30a) is located between a plane where the first side surface (PLa) is located and a plane where a boundary of the protective adhesive layer (80) away from the bending portion (130) is located.

3. The display module (200) according to claim 2, wherein a distance (H3) between the first side surface (PLa) and the second side surface (30a) is greater than or equal to 100 micrometers and less than or equal to 300 micrometers.

4. The display module (200) according to claim 1, wherein the buffer member (30) comprises a third side surface (30b) away from the bending portion (130), and the third side surface (30b) is coplanar with a plane where a boundary of the protective adhesive layer (80) away from the bending portion (130) is located.

5. The display module (200) according to claim 1, further comprising a driver chip (IC) disposed on a side of the second body (120) away from the first body (110), wherein the buffer member (30) comprises a third side surface (30b) away from the bending portion (130); and
wherein the third side surface (30b) is located between the driver chip (IC) and the protective adhesive layer (80); or
an orthographic projection of the third side surface (30b) on the second body (120) is located within an orthographic projection of the driver chip (IC) on the second body (120); or
the third side surface (30b) is coplanar with a side surface of the driver chip (IC) away from the protective adhesive layer (80).

6. The display module (200) according to claim 1, further comprising a polarizer (PL) disposed on a side of the first body (110) away from the second body (120), wherein the polarizer (PL) comprises a first side surface (PLa) close to the bending portion (130), the buffer member (30) comprises a second side surface (30a) close to the bending portion (130), the first body (110) comprises a fourth side surface (110a) close to the bending portion (130), and a distance (H1) between the first side surface (PLa) and the fourth side surface (110a) is less than or equal to a distance (H2) between the second side surface (30a) and the fourth side surface (110a); and/or
the buffer member (30) comprises the second side surface (30a) close to the bending portion (130), and the second side surface (30a) is coplanar with a plane where a boundary of the protective adhesive layer (80) away from the bending portion (130) is located.

7. The display module (200) according to claim 1, wherein the buffer member (30) comprises a plurality of buffer units (310) arranged at intervals in a width direction (X) or/and a length direction (Y) of the display module (200).

8. The display module (200) according to claim 7, further comprising a polarizer (PL) disposed on a side of the first body (110) away from the second body (120), wherein among the plurality of buffer units (310) arranged in the width direction (X) of the display module (200), a distance between a boundary of an outermost one of the buffer units (310) and a boundary of the polarizer (PL) is greater than or equal to 100 micrometers and less than or equal to 300 micrometers.

9. The display module (200) according to any one of claims 1 to 8, wherein a surface of the buffer member (30) away from the second body (120) is flat surface.

10. The display module (200) according to any one of claims 1 to 8, wherein the buffer member (30) has a thickness greater than or equal to 0.2 millimeters.

11. The display module (200) according to any one of claims 1 to 8, wherein an elastic modulus of the buffer member (30) is less than an elastic modulus of the protective adhesive layer (80).

12. The display module (200) according to any one of claims 1 to 8, wherein the buffer member (30) has an elastic modulus greater than or equal to 500 KPa and less than or equal to 4 GPa.

13. The display module (200) according to any one of claims 1 to 8, wherein the buffer member (30) comprises a plurality of buffer portions disposed in a stacked configuration, and an elastic modulus of one of the buffer portions close to the second body (120) is less than an elastic modulus of one of the buffer portions away from the second body (120).

14. The display module (200) according to any one of claims 1 to 8, further comprising a cover plate layer (50) disposed on a side of the first body (110) away from the second body (120), wherein the cover plate layer (50) comprises a planar portion (510) and a curved portion (520) located at a periphery of the planar portion (510), and the curved portion (520) comprises a plurality of side sub-portions (521) located at a peripheral side of the planar portion (510) and a corner sub-portion (522) located between two adjacent ones of the side sub-portions (521); and
wherein the buffer member (30) partially overlaps one of the side sub-portions (521) corresponding to the bending portion (130) and partially overlaps the corner sub-portion (522) corresponding to the bending portion (130).

15. A display device (100), **characterized in that** the display device (100) comprises a middle frame (300) and the display module (200) as claimed in any one of claims 1 to 14 disposed in the middle frame (300), wherein a surface of the buffer member (30) away from the second body (120) is connected to the middle frame (300).
